# EUROPEAN PATENT SPECIFICATION

(11) **EP 1 582 546 B1**
(45) Date of publication and mention of the grant of the patent: **27.08.2008**
(21) Application number: 05007121.6
(22) Date of filing: 31.03.2005
(51) Int. Cl.: C08G 59/62, C08L 63/02, H01L 23/00

(54) **Epoxy resin composition for semiconductor encapsulation and semiconductor device using the same**
Epoxidharzzusammensetzung für Halbleitereinkapselung und daraus hergestellter Halbleiter
Composition de résine époxide pour l'encapsulation d'un dispositif semi-conducteur et dispositif semi-conducteur en résultant

(30) Priority: 31.03.2004 JP 2004105688
(43) Date of publication of application: 05.10.2005
(73) Proprietor: NITTO DENKO CORPORATION, Osaka (JP)
(72) Inventor: Uchida, Takahiro, Ibaraki-shi Osaka (JP); Shimizu, Masato, Ibaraki-shi Osaka (JP)
(74) Representative: Grünecker, Kinkeldey, Stockmair & Schwanhäusser Anwaltssozietät

(56) References cited:
- PATENT ABSTRACTS OF JAPAN vol. 1999, no. 13, 30 November 1999 (1999-11-30) & JP 11 228788 A (NITTO DENKO CORP), 24 August 1999 (1999-08-24)
- PATENT ABSTRACTS OF JAPAN vol. 2003, no. 12, 5 December 2003 (2003-12-05) & JP 2004 059700 A (MATSUSHITA ELECTRIC WORKS LTD), 26 February 2004 (2004-02-26)
- PATENT ABSTRACTS OF JAPAN vol. 1996, no. 10, 31 October 1996 (1996-10-31) & JP 08 157695 A (SHIN ETSU CHEM CO LTD), 18 June 1996 (1996-06-18)
- PATENT ABSTRACTS OF JAPAN vol. 2002, no. 12, 12 December 2002 (2002-12-12) & JP 2002 220511 A (MATSUSHITA ELECTRIC WORKS LTD), 9 August 2002 (2002-08-09)

## Description

### FIELD OF THE INVENTION

The present invention relates to an epoxy resin composition for semiconductor encapsulation which has improved adhesive force in application to package frames and is capable of inhibiting separation between the encapsulating resin and the frame/heat radiation plate during package molding. The invention further relates to a semiconductor device using the composition.

### BACKGROUND OF THE INVENTION

Semiconductor elements such as transistors, ICs, and LSIs are encapsulated in plastic packages or the like to produce semiconductor devices to be protected from the surrounding environment and to be able to handle the semiconductor elements. Typical examples of this kind of package forms include through-hole mount packages and surface mount packages.

The degree of integration and processing speed in semiconductor devices such as LSI chips are becoming higher recently. In addition, there is the trend toward higher mounting densities so as to meet the desire to attain size reduction and function advancement in electronic apparatus. From these standpoints, surface mount packages are coming to be mainly used in place of through-hole mount packages. Semiconductor devices employing surface mount packages have pins extending therefrom in plane arrangement, and these pins are directly fixed to a surface of a printed wiring board with a solder or the like. Since such surface mount type semiconductor devices have pins extending in plane arrangement, they are characterized by being thin, lightweight, and small and hence have an advantage that the area occupied thereby in the printed circuit board can be small. In addition, these semiconductor devices have a merit that mounting on both sides of a printed wiring board is possible.

On the other hand, in some kinds of through-hole mount packages, metallic parts (copper or Alloy 42), such as metallic frame parts and heat radiation plates, have a deposit of silver, palladium, etc. Also in the case of the surface mount packages, which have come to be mainly used in recent years, packages employing a heat radiation plate obtained by plating the surface of a metallic frame part with nickel are used. Especially in nickel-plated frames and heat radiation plates, there is a problem that separation occurs during package molding between the encapsulating resin part (cured resin) formed from the encapsulating material and the frame/heat radiation plate.

In producing such semiconductor devices, an encapsulating material containing a release agent is used so as to obtain releasability from the mold. Examples of the release agent include long-chain carboxylic acids such as stearic acid and palmitic acid, metal salts of long-chain carboxylic acids, such as zinc stearate and calcium stearate, and waxes such as carnauba wax, montan wax, and polyethylene waxes. However, such release agents show low adhesiveness to metallic frame parts and heat radiation plates and it has been proposed to use, e.g., a silicone wax modified with a polyalkylene glycol as a release agent (see document 1).

Document 1: JP-A-6-302724

### SUMMARY OF THE INVENTION

However, use of an encapsulating material containing the silicone wax modified with a polyalkylene glycol has a problem that when this encapsulating material has an inorganic filler content exceeding 75% by weight, it shows reduced adhesiveness to metallic frame parts and heat radiation plates and suffers separation from these.

The invention has been achieved under these circumstances. An object of the invention is to provide an epoxy resin composition for semiconductor encapsulation which has improved adhesive force in application to metallic frame parts/heat radiation plates and can be inhibited from suffering separation from metallic frame parts/heat radiation plates during molding. Another object of the invention is to provide a semiconductor device using the composition.

The present inventors made extensive studies in order to obtain an encapsulating material which has excellent adhesive force in application to metallic frame parts and heat radiation plates and can be inhibited from suffering separation from metallic frame parts and heat radiation plates during molding. The studies were made mainly on release agents among ingredients for encapsulating materials. As a result, it was unexpectedly found that use of a release agent represented by general formula (1) given above (ingredient (C)) improves not only releasability in molding but also adhesion between the encapsulating resin part formed and the metallic frame part or heat radiation plate even when the encapsulating material contains a large amount of an inorganic filler, whereby the occurrence of any trouble such as, e.g., separation between the encapsulating resin part and the adherend is inhibited. The invention has been thus achieved.

Thus, the invention provides, according to a first aspect thereof, an epoxy resin composition for semiconductor encapsulation which is for use in the resin encapsulation of semiconductor elements other than optical semiconductor elements (e.g., photoreceptors and light-emitting elements), the composition comprising the following ingredients (A) to (D) and having a content of ingredient (D) of 75-95% by weight based on the whole epoxy resin composition:
(A) an epoxy resin,
(B) a phenolic resin,
(C) a release agent represented by the following general formula (1): 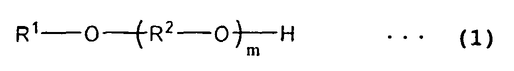 wherein R¹ is a monovalent aliphatic hydrocarbon group having 20-400 carbon atoms; R² is a divalent aliphatic hydrocarbon group having 2-7 carbon atoms; and m is a number which makes the partial molecular weight of (R²-O)ₘ to be 5-90% by weight of the molecular weight of the compound represented by formula (1), and
(D) an inorganic filler.

2. The epoxy resin composition for semiconductor encapsulation of 1. above, wherein the content of ingredient (C) is from 0.05 to 2% by weight based on the whole epoxy resin composition for semiconductor encapsulation.
3. The epoxy resin composition for semiconductor encapsulation of 1. or 2. above, which further comprises the following ingredient (E):
   (E) a silicon compound having at least one functional group selected from the group consisting of an epoxy group, a polyether group, a carboxyl group, a phenolic hydroxyl group, a thiol group, and an amino group.
4. The epoxy resin composition for semiconductor encapsulation of 3. above, wherein the content of ingredient (E) is 0.05-2% by weight based on the whole epoxy resin composition for semiconductor encapsulation.
5. The epoxy resin composition for semiconductor encapsulation of any one of 1. to 4. above, which further comprises an amine hardening accelerator.
6. The epoxy resin composition for semiconductor encapsulation of any one of 1. to 5. above, which is for use in the resin encapsulation of a semiconductor device comprising a lead frame having a nickel-plated surface.
7. A semiconductor device which comprises a semiconductor element and the epoxy resin composition for semiconductor encapsulation of any one of 1. to 6. above which encapsulates the semiconductor element.
8. The semiconductor device of 7. above, which further comprises a lead frame having a nickel-plated surface.

As described above, the invention provides an epoxy resin composition for semiconductor encapsulation which is for use in the resin encapsulation of semiconductor elements other than optical semiconductor elements including photoreceptors and light-emitting elements and contains a specific release agent represented by general formula (1) (ingredient (C)) in combination with an inorganic filler (ingredient (D)) contained in an amount within a specific range. Because of this constitution, the composition not only has high releasability from molds but also has improved adhesion to metallic frame parts and heat radiation plates even when the content of the inorganic filler in the composition is regulated to as high as, for example, above 75% by weight. As a result, the encapsulating material is inhibited from suffering separation from the metallic frame parts and heat radiation plates during mounting by soldering, and semiconductor devices having high reliability can be obtained.

Furthermore, when a specific silicon compound is incorporated besides the ingredients described above, adhesiveness to a metallic frame part, e.g., a lead frame, and a heat radiation plate which serve as components of a semiconductor device is further improved and the occurrence of troubles in mounting by soldering, such as separation and cracking, is inhibited. As a result, a semiconductor device having higher reliability can be obtained.

The epoxy resin composition for semiconductor encapsulation of the invention shows excellent adhesiveness to metallic frame parts and heat radiation plates which have a nickel-plated surface; such nickel-plated parts and plates show poorer adhesiveness to encapsulating resins than other metallic frame parts and heat radiation plates.

### BRIEF DESCRIPTION OF THE DRAWINGS

By way of example and to make the description more clear, reference is made to the accompanying drawing in which:
Fig. 1 is a perspective view showing a sample for adhesive force examination which is used in evaluating the adhesiveness of the cured resin formed from an epoxy resin composition, and
Fig. 2 is a view illustrating a method for examining the shear force required for separating the cured resin from the frame.

### DETAILED DESCRIPTION OF THE INVENTION

The epoxy resin composition for semiconductor encapsulation of the invention is obtained from an epoxy resin (ingredient A), a phenolic resin (ingredient B), a specific release agent (ingredient C), and an inorganic filler (ingredient D), and is generally in the form of a powder or tablets shaped from the powder by compressing.

The semiconductor elements which can be encapsulated with the epoxy resin composition for semiconductor encapsulation of the present invention are elements which function without being accompanied by light incidence or emission, i.e., semiconductor elements other than optical semiconductor elements including photoreceptors and light-emitting elements (e.g., light-emitting diodes).

The epoxy resin (ingredient A) is not particularly limited, and a compound having 2 or more epoxy groups in the molecule is used. Examples thereof include bisphenol A epoxy resins, phenol-novolac epoxy resins, cresol-novolac epoxy resins, biphenyl type epoxy resins, and triphenylmethane type epoxy resins. These may be used alone or in combination of two or more thereof. From the standpoint of reliability, it is preferred to use a biphenyl type epoxy resin or a lowly hygroscopic epoxy resin, such as that having phenyl rings to which a lower alkyl group has added, among those epoxy resins. Such epoxy resins preferably are ones having an epoxy equivalent of 150 to 250 and a softening point or melting point of 50 to 130°C.

The phenolic resin (ingredient B), which is used in combination with the epoxy resin (ingredient A), functions as a hardener for the epoxy resin and is not particularly limited. It means any of various monomers, oligomers, and polymers each having 2 or more phenolic hydroxyl groups in the molecule. Examples thereof include phenolic novolacs, cresylic novolacs, biphenyl type novolacs, triphenylmethane type novolacs, naphthol novolacs, phenol-aralkyl resins, and biphenyl-aralkyl resins. These may be used alone or in combination of two or more thereof. From the standpoint of reliability, it is preferred to use a lowly hygroscopic phenolic resin, such as a phenol-aralkyl resin or biphenyl-aralkyl resin, among those resins.

The epoxy resin (ingredient A) and the phenolic resin (ingredient B) are incorporated preferably in such a proportion that the amount of the hydroxyl groups in the phenolic resin is 0.7 to 1.3 equivalents, more preferably 0.8 to 1.2 equivalents, to the epoxy groups in the epoxy resin.

The specific release agent (ingredient C), which is used in combination with ingredients A and B, is a compound represented by the following general formula (1). In the invention, by using this specific release agent (ingredient C), an epoxy resin composition for semiconductor encapsulation having high releasability from molds and excellent adhesiveness to metallic frame parts and heat radiation plates is obtained. 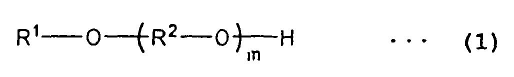 (In formula (1), R¹ is a monovalent aliphatic hydrocarbon group having 20 to 400 carbon atoms; R² is a divalent aliphatic hydrocarbon group having 2 to 7 carbon atoms; and m is a number which makes the partial molecular weight of (R²-O)ₘ account for 5 to 90% by weight of the molecular weight of the compound represented by formula (1).)

In general formula (1), R¹ is a monovalent aliphatic hydrocarbon group having 2.0 to 400 carbon atoms. This is because carbon numbers smaller than 20 result in impaired releasability, while carbon numbers exceeding 400 result in impaired dispersibility in the epoxy resin composition and hence in an impaired molding appearance. R¹ preferably is a linear aliphatic hydrocarbon group, and especially preferably is, for example, an ethylene oligomer.

In general formula (1), R² is a divalent aliphatic hydrocarbon group having 2 to 7 carbon atoms. Examples thereof include ethylene, propylene, butylene, pentamethylene, hexamethylene, and heptamethylene.

Symbol m in general formula (1), which means the number of repetitions, is a number which makes the partial molecular weight of (R²O)ₘ account for 5 to 90% by weight of the molecular weight of the whole compound represented by formula (1). This is because proportions of the partial molecular weight lower than 5% by weight may result in impaired adhesiveness to frames and other parts, while proportions thereof exceeding 90% by weight may result in impaired releasability from molds.

The compound represented by general formula (1) can be synthesized, for example, by the addition reaction of a cyclic oxygen-containing compound such as ethylene oxide, propylene oxide, or hexahydrofuran with R¹OH.

Specific examples of the compound represented by general formula (1) include the following various compounds. These may be used alone or in combination of two or more thereof.

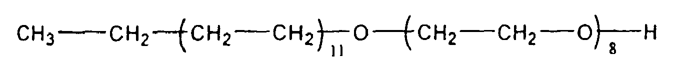

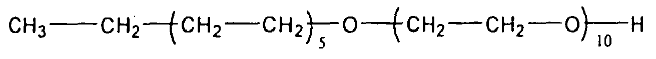

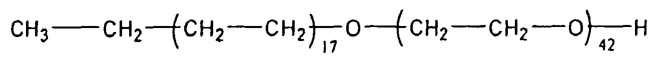

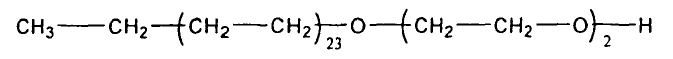

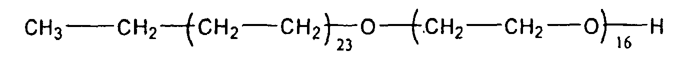

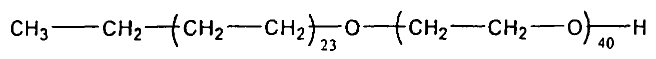

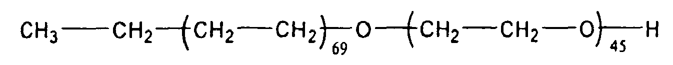

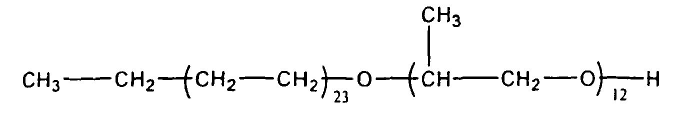

The content of the specific release agent (ingredient C) is in the range of preferably 0.05 to 2% by weight, especially preferably 0.1 to 1% by weight, based on the whole epoxy resin composition for semiconductor encapsulation. The reasons for this are as follows. In case where the content of the release agent is lower than 0.05% by weight, the encapsulating resin may have reduced releasability from molds. On the other hand, in case where the content thereof exceeds 2% by weight, the encapsulating resin may have enhanced hygroscopicity and this tends to result in the occurrence of failures concerning moisture resistance reliability.

The inorganic filler (ingredient D), which is used in combination with ingredients A to C, is not particularly limited and various known fillers may be used. Examples thereof include a quartz glass powder, talc, silica powder, alumina powder, aluminum nitride, and silicon nitride powder. These inorganic fillers can be in any form such as, e.g., pulverized particles, spherical particles, or ground particles. It is preferred to use a silica powder among those fillers because it can impart a reduced coefficient of linear expansion to the cured resin obtained. As the silica powder may be used a fused silica powder, a crystalline silica powder, or the like. Those inorganic fillers may be used alone or in combination of two or more thereof.

The content of the inorganic filler (ingredient D) should be in the range of 75 to 95% by weight based on the whole epoxy resin composition. The reasons for this are as follows. In case where the content of the filler is lower than 75% by weight, the encapsulating resin may absorb moisture in an increased amount and may have an impaired thermal conductivity and reduced resin strength, resulting in cracks or separation during semiconductor package reflow. In case where the content thereof exceeds 95% by weight, the epoxy resin composition may have impaired flowability and is incapable of molding.

A silicon compound (ingredient E) may be used in the invention besides ingredients A to D. Use of the silicon compound (ingredient E) in combination with the specific release agent (ingredient C) produces a synergistic effect to give an epoxy resin composition for semiconductor encapsulation with which a semiconductor device having higher reliability can be obtained. In this device, the encapsulating resin has further improved adhesiveness to the constituent metallic frame parts, e.g., lead frame, and heat radiation plate and the occurrence of troubles in mounting by soldering, such as separation and cracking, is inhibited.

The silicon compound (ingredient E) to be used preferably is a silicon compound having at least one functional groups selected from the group consisting of epoxy, polyether, carboxyl, phenolic hydroxyl, thiol, and amino groups. Examples of such compounds include silane coupling agents and organopolysiloxanes having one or more of those functional groups.

The silane coupling agents are not particularly limited and various silane coupling agents can be used. Examples thereof include aminosilane coupling agents such as γ-aminopropylmethyldimethoxysilane, epoxysilane coupling agents such as γ-glycidoxypropyltrimethoxysilane, and mercaptosilane coupling agents such as γ-mercaptopropyltrimethoxysilane. These may be used alone or in combination of two or more thereof.

Examples of the organopolysiloxanes having one or more functional groups include ones represented by the following general formula (2), which contain at least one functional group selected from the group consisting of epoxy, polyether, carboxyl, phenolic hydroxyl, thiol, and amino groups. Of these organopolysiloxanes, ones having a polyether group and one or more other functional groups are excellent in release agent dispersibility and in adhesiveness to metallic frames, etc. 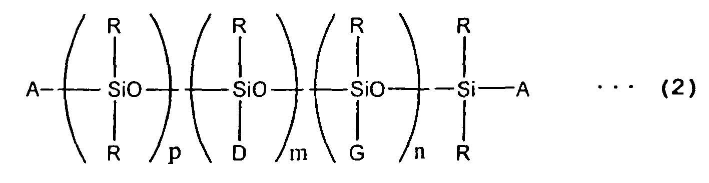 (In formula (2), R's may be the same or different and each are a monovalent hydrocarbon group; D is a monovalent organic group containing any of epoxy, carboxyl, phenolic hydroxyl, thiol, and amino groups; G is a group represented by the following general formula (3); and A's may be the same or different and each are one member selected from R, D, and G. Symbol p is an integer of 1 to 1,000 and m and n each are an integer of 0 to 100, provided that when A's are neither D nor G, either of m and n is not 0. 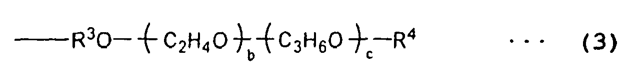 (In formula (3), R³ is a divalent organic group; R⁴ is -H or a monovalent organic group; and b and c each are an integer of 0 to 50, provided that b+c is 1 to 100.))

In general formula (2), R's may be the same or different and each are a monovalent hydrocarbon group. Examples thereof include aliphatic alkyl groups such as methyl, ethyl, and propyl, alicyclic alkyl groups such as cyclohexyl, aryl groups such as phenyl, and aralkyl groups such as benzyl. Methyl is preferred of these groups because it brings about satisfactory releasability. The number of repetitions, p, preferably is an integer of 1 to 1,000 from the standpoint of releasability, and is especially preferably an integer of 10 to 500. This is because too small repetition numbers p may result in difficulties in obtaining sufficient releasability, while too large repetition numbers p tend to result in impaired dispersibility in the epoxy resin composition.

The compounds represented by general formula (2) contain at least one functional group selected from the group consisting of epoxy, polyether, carboxyl, phenolic hydroxyl, thiol, and amino groups. D in formula (2) contains a group selected from the group consisting of epoxy, carboxyl, phenolic hydroxyl, thiol, and amino groups, and the number of repetitions, m, is an integer of 0 to 100. G in formula (2) represents a polyether group represented by formula (3), and the number of repetitions, n, is an integer of 0 to 100. Furthermore, A's in formula (2) may be the same or different and each are one member selected from the R, D, and G described above. When the A's are neither D nor G, either of the repetition numbers m and n is not 0.

Examples of the compounds represented by general formula (2) include compounds having amino, carboxyl, or phenolic hydroxyl groups at terminals and compounds having groups selected from epoxy, polyether, carboxyl, phenolic hydroxyl, thiol, and amino groups in side chains.

The content of the silicon compound (ingredient E) is in the range of preferably 0.05 to 2% by weight, especially preferably 0.1 to 1% by weight, based on the whole epoxy resin composition for semiconductor encapsulation. The reasons for this are as follows. In case where the content of the silicon compound is lower than 0.05% by weight, this ingredient may not produce the effect of greatly improving adhesive force even when used in combination with the specific release agent (ingredient C). In case where the content thereof exceeds 2% by weight, the encapsulating resin has enhanced hygroscopicity and this tends to result in the occurrence of failures concerning moisture resistance reliability.

In addition to the ingredients A to E, other additives can be suitably incorporated into the epoxy resin composition for semiconductor encapsulation of the invention. Examples of the additives include a hardening accelerator, flame retardant, flame retardant aid, ion-trapping agent, pigment or colorant such as carbon black, stress-relieving agent, and tackifier.

The hardening accelerator is not particularly limited and various known hardening accelerators may be used. Examples thereof include amine compounds and phosphorus compounds. Examples of the amine hardening accelerators include imidazole compounds such as 2-methylimidazole and tertiary amines such as triethanolamine and 1,8-diazabicyclo[5.4.0]undecene-7. Examples of the phosphorus compound hardening accelerators include triarylphosphines such as triphenylphosphine and tetraphenylphosphonium tetraphenylborate. These may be used alone or in combination of two or more thereof. It is preferred to use a tertiary amine such as triethanolamine or 1,8-diazabicyclo[5.4.0]undecene-7 among those hardening accelerators because use of such a tertiary amine improves the adhesiveness of the encapsulating resin to a metallic frame part, e.g., lead frame, and heat radiation plate which serve as components of the semiconductor device and inhibits separation of the encapsulating resin from the metallic frame part and heat radiation plate during molding. The content of the hardening accelerator is in the range of preferably 1 to 20 parts by weight (hereinafter abbreviated as "parts"), more preferably 2-15 parts, per 100 parts of the phenolic resin (ingredient B). The reasons for this are as follows. In case where the content of the hardening accelerator is lower than 1 part, the desired hardening reaction between the epoxy resin (ingredient A) and the phenolic resin (ingredient B) is less apt to proceed and it is hence difficult to obtain sufficient hardening properties. In case where the content thereof exceeds 20 parts, the hardening reaction tends to proceed too rapidly, resulting in impaired moldability.

Examples of the flame retardant include halogen compound flame retardants such as novolac type brominated epoxy resins. As the flame retardant aid may be used diantimony trioxide, diantimony pentoxide, or the like. These may be used alone or in combination of two or more thereof.

Besides those halogen compound flame retardants, a polyhedral metal hydroxide represented by the following general formula (4) can be used. This metal hydroxide is one which has a polyhedral crystal form and does not have a thin platy crystal form such as those of the metal hydroxides heretofore in use which have a hexagonal platy form, flaky form, or the like. Namely, it is a metal hydroxide made up of crystals sufficiently grown not only in the length and width directions but in the thickness direction (c-axis direction), e.g., one having a crystal form resulting from the growth of a platy crystal form in the thickness direction (c-axis direction) into a more three-dimensional particulate crystal form akin to spheres. For example, it is a metal hydroxide having a crystal form such as a nearly dodecahedral, nearly octahedral, or nearly tetrahedral form.

m(MₐO_{b})·n(Q_{d}Oₑ)·cH₂O (4)

(In formula (4), M and Q are different metallic elements, and Q is a metallic element belonging to a group selected from groups IVa, Va, VIa, VIIa, VIII, Ib, and IIb of the periodic table. Symbols m, n, a, b, c, d, and e are positive numbers, and may be the same or different.)

With respect to the metal hydroxide represented by general formula (4), examples of M in formula (4), which represents a metallic element, include Al, Mg, Ca, Ni, Co, Sn, Zn, Cu, Fe, and Ti.

In the metal hydroxide represented by general formula (4), Q, which represents another metallic element, is a metal belonging to a group selected from groups IVa, Va, VIa, VIIa, VIII, Ib, and IIb of the periodic table. Examples thereof include Fe, Co, Ni, Pd, Cu, and Zn. Any one of or a combination of two or more of these is selected.

Such a metal hydroxide having a polyhedral crystal form can be obtained, for example, by regulating various conditions in a process for producing the metal hydroxide. A metal hydroxide which has undergone sufficient crystal growth not only in the length and width directions but in the thickness direction (c-axis direction) and has a desired polyhedral crystal form, e.g., a nearly dodecahedral, nearly octahedral, or nearly tetrahedral form, can be obtained. Usually, the metal hydroxide obtained is a mixture of two or more of such crystal forms.

Typical examples of the metal hydroxide having a polyhedral crystal form include magnesium oxide-nickel oxide hydrates, magnesium oxide-zinc oxide hydrates, and magnesium oxide-copper oxide hydrates.

The metal hydroxide having a polyhedral crystal form preferably is one having a maximum particle diameter of 10 µm or smaller, especially preferably 6 µm or smaller. Furthermore, the specific surface area of the metal hydroxide having a polyhedral crystal form is preferably in the range of 2.0 to 4.0 m²/g. The specific surface area of the metal hydroxide having a polyhedral crystal form is measured by the BET adsorption method.

The aspect ratio of the metal hydroxide having a polyhedral crystal form is generally 1 to 8, preferably 1 to 7, especially preferably 1 to 4. The term "aspect ratio" herein means the ratio of the length of the major axis to the length of the minor axis of the metal hydroxide. In case where the aspect ratio of the metal hydroxide exceeds 8, the epoxy resin composition containing this metal hydroxide has an increased melt viscosity. Namely, the effect of viscosity reduction is lessened.

As the ion-trapping agent can be used any of all known compounds having the ability to trap ions. For example, a hydrotalcite or bismuth hydroxide is used.

Examples of the stress-relieving agent include butadiene rubbers, such as methyl acrylate/butadiene/styrene copolymers and methyl methacrylate/butadiene/styrene copolymers, and silicone compounds.

The epoxy resin composition for semiconductor encapsulation of the invention may be produced, for example, in the following manner. Namely, the composition may be produced through a series of steps comprising mixing ingredients A to E described above optionally together with other additives, treating the mixture with a kneading machine, e.g., heated rolls or a kneader, to melt and mix the ingredients with heating, cooling the melt to room temperature, subsequently pulverizing it by a known technique, and compressing the powder to tablets according to need.

Methods for encapsulating a semiconductor element with the epoxy resin composition are not particularly limited. The encapsulation can be conducted by a known molding method such as, e.g., ordinary transfer molding. Thus, a semiconductor device can be produced.

In the case where the epoxy resin composition for semiconductor encapsulation of the invention is used as an encapsulating material, examples of metallic frame parts and heat radiation plates for which application of the composition is suitable are as follows. From the standpoint of improving adhesiveness to metallic frame parts, e.g., lead frames, examples of the lead frames include ones having a nickel deposit layer as the outermost layer; any encapsulating material heretofore in use failed to have sufficient adhesive force in application to this kind of lead frames. Examples of the heat radiation plates include ones having a nickel deposit layer on the surface thereof. The nickel deposit layer is generally formed by nickel-plating the surface of a raw lead frame or heat radiation plate which is made of copper or a copper alloy. Such members plated with nickel generally have poor adhesion to cured encapsulating resins. However, when the epoxy resin composition for semiconductor encapsulation of the invention is used, the cured encapsulating resin obtained therefrom shows excellent adhesiveness because it contains the specific release agent (ingredient C). As a result, the occurrence of separation and other troubles are inhibited and a highly reliable semiconductor device is obtained.

The invention will be explained below by reference to Examples and Comparative Examples.

Prior to Examples, the following ingredients were prepared.

### Epoxy Resin A

o-Cresol-novolac epoxy resin (epoxy equivalent, 195; softening point 70°C)

### Epoxy Resin B

Brominated novolac epoxy resin (epoxy equivalent, 455; softening point, 80°C)

### Epoxy Resin C

Biphenyl type epoxy resin [4,4'-bis(2,3-epoxypropoxy)-3,3',5,5'-tetramethylbiphenyl: epoxy equivalent, 193; melting point, 105°C]

### Phenolic Resin

Phenolic novolac resin (hydroxyl equivalent, 105; softening point, 83°C)

### Release Agent A

Compound represented by the following structural formula (a) [molecular weight, 1,380; corresponding to general formula (1) wherein R¹ is C₄₈H₉₇, R² is C₂H₄, and m is 16]

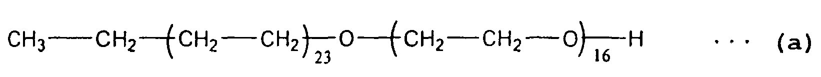

### Release Agent B

Carnauba wax

### Silicone Oil A

Compound represented by the following structural formula (b) (molecular weight, 31,000; epoxy equivalent, 7,800)

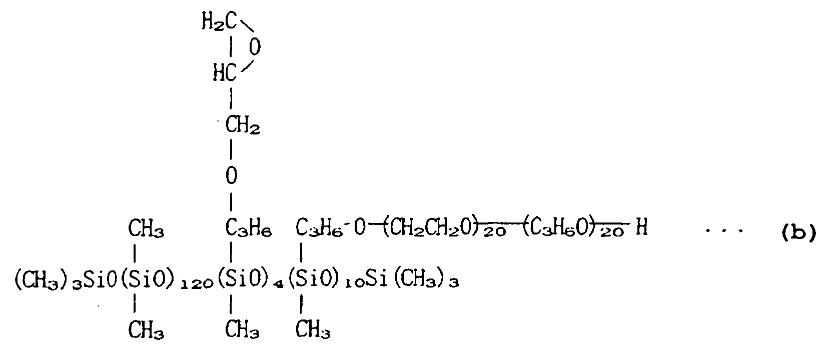

### Silicone Oil B

Compound represented by the following structural formula (c) (molecular weight, 22,000; amino equivalent, 600)

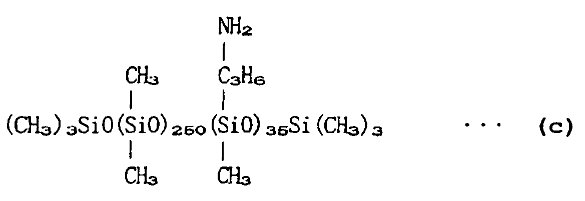

### Hardening Accelerator A

1,8-Diazabicyclo[5.4.0]undecane-7

### Hardening Accelerator B

Tetraphenylphosphonium tetraphenylborate

### Silica Powder A

Crystalline silica powder; powder having an average particle diameter of 20 µm and a maximum particle diameter of 75 µm

### Silica Powder B

Spherical fused silica powder having an average particle diameter of 49 µm, maximum particle diameter of 100 µm, and Wardell's sphericity of 0.85 [Wardell's sphericity = (diameter of circle having the same area as the projected area of the particle)/(diameter of minimum circumscribed circle of the particle)]

### Silane Coupling Agent

γ-Mercaptopropyltrimethoxysilane

### Carbon Black

### Diantimony Trioxide

### EXAMPLES 1 TO 13 AND COMPARATIVE EXAMPLES 1 TO 5

The ingredients shown in Tables 1 and 2 were mixed together according to the proportion shown therein. This mixture was treated with a mixing roll kneading machine heated at 80°C (for 1 minute) and thus melt-knead. Subsequently, this melt was cooled, pulverized, and then tableted. Thus, target epoxy resin compositions for semiconductor encapsulation were obtained.

**Table 1**

| **(parts)** | | | | | | | | | |
|---|---|---|---|---|---|---|---|---|---|
| | | Example | | | | | | | |
| | | 1 | 2 | 3 | 4 | 5 | 6 | 7 | 8 |
| Epoxy resin | A | 100 | 100 | 100 | 100 | 100 | 100 | 100 | 100 |
| | B | 20 | 20 | 20 | 20 | 20 | 20 | 20 | 20 |
| Phenolic resin | | 59 | 59 | 59 | 59 | 59 | 59 | 59 | 59 |
| Release agent | A | 5.5 | 1.5 | 5.5 | 5.5 | 5.5 | 11 | 5.5 | 5.5 |
| | B | - | - | - | - | - | - | - | - |
| Silicone oil | A | - | 5.5 | 1.5 | 5.5 | 11 | 5.5 | - | - |
| | B | - | - | - | - | - | - | 5.5 | 5.5 |
| Hardening accelerator | A | 1 | 1 | 1 | 1 | 1 | 1 | 1 | - |
| | B | - | - | - | - | - | - | - | 3 |
| Carbon black | | 2 | 2 | 2 | 2 | 2 | 2 | 2 | 2 |
| Sb₂O₃ | | 24 | 24 | 24 | 24 | 24 | 24 | 24 | 24 |
| Silica powder A | | 918 | 925 | 925 | 925 | 925 | 925 | 925 | 925 |
| Silane coupling agent | | 0.4 | 0.4 | 0.4 | 0.4 | 0.4 | 0.4 | 0.4 | 0.4 |
| Content of release agent in whole epoxy resin composition (wt%) | | 0.5 | 0.1 | 0.5 | 0.5 | 0.5 | 1.0 | 0.5 | 0.5 |
| Content of silicone oil in whole epoxy resin composition (wt%) | | - | 0.5 | 0.1 | 0.5 | 1.0 | 0.5 | 0.5 | 0.5 |
| Content of silica powder in whole epoxy resin composition (wt%) | | 81 | 81 | 81 | 81 | 81 | 81 | 81 | 81 |

**TABLE 2**

| **(parts)** | | | | | | | | | | | |
|---|---|---|---|---|---|---|---|---|---|---|---|
| | | Example | | | | | Comparative Example | | | | |
| | | 9 | 10 | 11 | 12 | 13 | 1 | 2 | 3 | 4 | 5 |
| Epoxy resin | A | 100 | 100 | 100 | 100 | - | 100 | 100 | 100 | 100 | - |
| | B | 20 | 20 | 20 | 20 | - | 20 | 20 | 20 | 20 | - |
| | C | 20 | 20 | 20 | 20 | 100 | 20 | 20 | 20 | 20 | 100 |
| Phenolic resin | | 59 | 59 | 59 | 59 | 50 | 59 | 59 | 59 | 59 | 50 |
| Release agent | A | 0.6 | 22 | 5.5 | 0.6 | 2.0 | - | - | - | - | - |
| | B | - | - | - | - | - | 5.5 | 5.5 | 5.5 | 5.5 | 2.0 |
| Silicone oil | A | - | - | 0.6 | 22 | 15 | 5.5 | - | - | - | - |
| | B | - | - | - | - | - | - | - | 5.5 | 5.5 | 15 |
| Hardening accelerator | A | 1 | 1 | 1 | 1 | 1 | 1 | 1 | 1 | - | 1 |
| | B | - | - | - | - | - | - | - | - | 3 | - |
| Carbon black | | 2 | 2 | 2 | 2 | 2 | 2 | 2 | 2 | 2 | 2 |
| Sb₂O₃ | | 24 | 24 | 24 | 24 | - | 24 | 24 | 24 | 24 | - |
| Silica powder | A | 918 | 925 | 925 | 925 | - | 925 | 925 | 925 | 925 | - |
| | B | - | - | - | - | 2260 | - | - | - | - | 2260 |
| Silane coupling agent | | 0.4 | 0.4 | 0.4 | 0.4 | 0.4 | 0.4 | 0.4 | 0.4 | 0.4 | 0.4 |
| Content of release agent in whole epoxy resin composition (wt%) | | 0.05 | 2.0 | 0.5 | 0.05 | 0.1 | 0.5 | 0.5 | 0.5 | 0.5 | 0.1 |
| Content of silicone oil in whole epoxy resin composition (wt%) | | - | - | 0.05 | 2.0 | 0.5 | 0.5 | - | 0.5 | 0.5 | 0.5 |
| Content of silica powder in whole epoxy resin composition (wt%) | | 82 | 80 | 81 | 80 | 93 | 81 | 81 | 81 | 81 | 93 |

The epoxy resin compositions of Examples and Comparative Examples thus obtained were examined/evaluated for adhesiveness and for frame separation during molding. The results thereof are shown in Tables 3 and 4.

### Adhesiveness

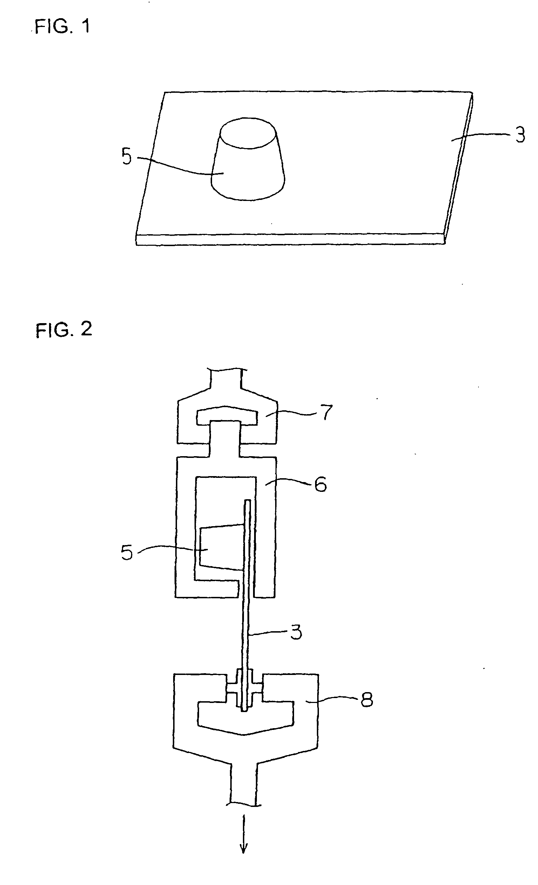

Each epoxy resin composition and a metallic frame plate were used to mold a sample for adhesive force measurement by transfer molding (175°C × 2 minutes and 175°C × 5 hours for postcure). As shown in Fig. 1, this sample comprised the metallic frame plate 3 and, formed on a left-end surface thereof, a cured resin 5 in the form of a frustum of cone (area of bonding part, 10 mm²). As shown in Fig. 2, the cured resin 5 was held by a jig 6 and an end of this jig 6 was fixed to a holder 7 of a tensile strength tester. The other end of the metallic frame plate 3 of the sample was fixed to the other holder 8 of the tensile strength tester. Loads were applied in the direction indicated by the arrow, and the shear force required for the cured resin 5 on the surface of the metallic frame plate 3 to separate from the metallic frame plate 3 was measured. This value of shear force was taken as adhesive force. In the measurement, two kinds of metallic frame plates 3 were used, i.e., one plated with nickel (frame obtained by copper-plating the surface of raw copper material) and one made of copper without plating).

Furthermore, each of the epoxy resin compositions obtained in the Examples and Comparative Examples was used to encapsulate a semiconductor element by transfer molding (conditions: 175°C × 2 minutes). Postcure was then conducted at 175°C for 5 hours to obtain a semiconductor device, which was TO-220 (transistor package having a lead frame obtained by plating the surface of a raw copper material with nickel and having a heat radiation plate).

### Separation at Interface with Lead Frame

These semiconductor devices were examined for separation at the interface between the lead frame and the encapsulating resin layer (cured resin). The semiconductor devices which had suffered no separation are indicated by "O", while those which had suffered separation at the interface are indicated by "X". The examination for interfacial separation was made with an ultrasonic microscope.

**Table 3**

| | | Example | | | | | | | |
|---|---|---|---|---|---|---|---|---|---|
| | | 1 | 2 | 3 | 4 | 5 | 6 | 7 | 8 |
| Adhesive force (MPa) | Ni deposit | 4.3 | 2.0 | 5.0 | 6.2 | 7.8 | 6.7 | 6.0 | 4.5 |
| | copper | 6.3 | 5.8 | 7.3 | 9.1 | 11 | 9.8 | 8.1 | 6.5 |
| Separation at interface with lead frame | | ○ | ○ | ○ | ○ | ○ | ○ | ○ | ○ |

**Table 4**

| | | Example | | | | | Comparative Example | | | | |
|---|---|---|---|---|---|---|---|---|---|---|---|
| | | 9 | 10 | 11 | 12 | 13 | 1 | 2 | 3 | 4 | 5 |
| Adhesive force(MPa) | Ni deposit | 1.0 | 9.0 | 6.5 | 7.0 | 3.0 | 0 | 0 | 0 | 0 | 0 |
| | copper | 5.0 | 12 | 9 | 10 | 6.0 | 5.0 | 3.0 | 4.5 | 4.0 | 5.9 |
| Separation at interface with lead frame | | ○ | ○ | ○ | ○ | ○ | X | X | X | X | X |

The results given above show the following. The compositions obtained in the Examples showed high adhesive forces in application to the metallic frame plates although they had a silica powder content as high as above 80% by weight. Furthermore, the results of the examination for separation from the lead frame during molding show that no separation had occurred and highly reliable semiconductor devices were obtained. In particular, in application to the frame plate obtained by nickel-plating the surface of a raw copper material, high adhesive forces which had not been attained were obtained. In contrast, the compositions obtained in the Comparative Examples had lower adhesive forces than the compositions of the Examples in application to both the frame plate obtained by nickel-plating the surface of a raw copper material and the frame plate made of copper. The encapsulating resins formed from these compositions had suffered separation at the interface with the lead frame, and the semiconductor devices obtained therewith had poor reliability.

## Claims

1. An epoxy resin composition for semiconductor encapsulation which is for use in the resin encapsulation of semiconductor elements other than optical semiconductor elements, the composition comprising the following ingredients (A) to (D) and having a content of ingredient (D) of 75-95% by weight based on the whole epoxy resin composition:
(A) an epoxy resin,
(B) a phenolic resin,
(C) a release agent represented by the following general formula (1) : 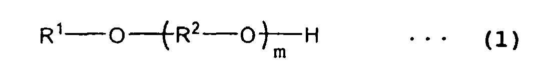 wherein R¹ is a monovalent aliphatic hydrocarbon group having 20-400 carbon atoms; R² is a divalent aliphatic hydrocarbon group having 2-7 carbon atoms; and m is a number which makes the partial molecular weight of (R²-O)ₘ to be from 5 to 90% by weight of the molecular weight of the compound represented by formula (1), and
(D) an inorganic filler.

2. The epoxy resin composition for semiconductor encapsulation of claim 1, wherein the content of ingredient (C) is from 0.05 to 2% by weight based on the whole epoxy resin composition for semiconductor encapsulation.

3. The epoxy resin composition for semiconductor encapsulation of claim 1, which further comprises the following ingredient (E):
(E) a silicon compound having at least one functional group selected from the group consisting of an epoxy group, a polyether group, a carboxyl group, a phenolic hydroxyl group, a thiol group, and an amino group.

4. The epoxy resin composition for semiconductor encapsulation of claim 3, wherein the content of ingredient (E) is 0.05-2% by weight based on the whole epoxy resin composition for semiconductor encapsulation.

5. The epoxy resin composition for semiconductor encapsulation of claim 1, which further comprises an amine hardening accelerator.

6. The epoxy resin composition for semiconductor encapsulation of claim 1, which is for use in the resin encapsulation of a semiconductor device comprising a lead frame having a nickel-plated surface.

7. A semiconductor device which comprises a semiconductor element and the epoxy resin composition for semiconductor encapsulation of claims 1 which encapsulates the semiconductor element.

8. The semiconductor device of claim 7, which further comprises a lead frame having a nickel-plated surface.

## Patentansprüche

1. Epoxyharzzusammensetzung zur Einkapselung von Halbleitern, die zur Harzeinkapselung von Halbleiterbauelementen, die keine optischen Halbleiterbauelemente sind, verwendbar ist, wobei die Zusammensetzung die folgenden Bestandteile (A) bis (D) umfasst und einen Gehalt des Bestandteiles (D) von 75-95 Gew.-%, basierend auf der gesamten Epoxyharzzusammensetzung, hat:
(A) ein Epoxyharz,
(B) ein phenolisches Harz,
(C) ein Trennmittel, das durch die folgende allgemeine Formel (1) dargestellt ist: 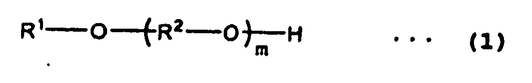 worin R¹ eine einwertige aliphatische Kohlenwasserstoffgruppe ist, die 20-400 Kohlenstoffatome hat; R² eine zweiwertige aliphatische Kohlenwasserstoffgruppe ist, die 2-7 Kohlenstoffatome hat; und m eine Zahl ist, die bewirkt, dass das partielle Molekulargewicht von (R²-O)ₘ von 5 bis 90 Gew.-% des Molekulargewichts der Verbindung ist, die durch die Formel (1) dargestellt ist, und
(D) ein anorganischer Füllstoff.

2. Epoxyharzzusammensetzung zur Einkapselung von Halbleitern nach Anspruch 1, wobei der Gehalt des Bestandteils (C) von 0,05 bis 2 Gew.-%, basierend auf der gesamten Epoxyharzzusammensetzung zur Einkapselung von Halbleitern ist.

3. Epoxyharzzusammensetzung zur Einkapselung von Halbleitern nach Anspruch 1, die zusätzlich den folgenden Bestandteil (E) umfasst:
(E) eine Silikonverbindung, die mindestens eine funktionelle Gruppe hat, ausgewählt aus der Gruppe bestehend aus einer Epoxygruppe, einer Polyethergruppe, einer Carboxylgruppe, einer phenolischen Hydroxylgruppe, einer Thiolgruppe, und einer Aminogruppe.

4. Epoxyharzzusammensetzung zur Einkapselung von Halbleitern nach Anspruch 3, worin der Gehalt des Bestandteils (E) 0,05 bis 2 Gew.%, basierend auf der gesamten Expoxyharzzusammensetzung zur Einkapselung von Halbleitern ist.

5. Epoxyharzzusammensetzung zur Einkapselung von Halbleitern nach Anspruch 1, die weiter einen Amin-Härtungsbeschleuniger umfasst.

6. Epoxyharzzusammensetzung zur Einkapselung von Halbleitern nach Anspruch 1, die zur Harzeinkapselung eines Halbleiterbauteils verwendbar ist, welches einen Leiterrahmen umfasst, der eine vernickelte Oberfläche hat.

7. Halbeiterbauteil, umfassend ein Halbleiterbauelement und die Epoxyharzzusammensetzung zur Einkapselung von Halbleitern nach Anspruch 1, die das Halbleiterbauelement einkapselt.

8. Halbleiterbauteil nach Anspruch 7, weiter umfassend einen Leiterrahmen, der eine vernickelte Oberfläche hat.

## Revendications

1. Composition de résine époxy pour une encapsulation de semi-conducteur qui est destinée à l'utilisation dans l'encapsulation de résine d'éléments semi-conducteurs différents d'éléments semi-conducteurs optiques, la composition comprenant les ingrédients (A) à (D) suivants et ayant une teneur en ingrédient (D) de 75-95 % en poids rapportée à la composition de résine époxy globale :
(A) une résine époxy,
(B) une résine phénolique,
(C) un agent de démoulage représenté par la formule générale (1) suivante : 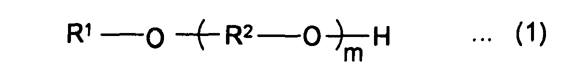 dans laquelle R¹ est un groupe hydrocarboné aliphatique monovalent ayant 20-400 atomes de carbone ; R² est un groupe hydrocarboné aliphatique divalent ayant 2-7 atomes de carbone ; et m est un nombre qui fait que le poids moléculaire partiel de (R²-O)ₘ est de 5 à 90 % en poids du poids moléculaire du composé représenté par la formule (1), et
(D) une charge inorganique.

2. Composition de résine époxy pour une encapsulation de semi-conducteur selon la revendication 1, dans laquelle la teneur de l'ingrédient (C) est de 0,05 à 2 % en poids rapporté à la composition de résine époxy globale pour une encapsulation de semi-conducteur.

3. Composition de résine époxy pour une encapsulation de semi-conducteur selon la revendication 1, laquelle comprend de plus l'ingrédient (E) suivant :
(E) un composé du silicium présentant au moins un groupe fonctionnel choisi parmi un groupe époxy, un groupe polyéther, un groupe carboxyle, un groupe hydroxyle phénolique, un groupe thiol et un groupe amino.

4. Composition de résine époxy pour une encapsulation de semi-conducteur selon la revendication 3, dans laquelle la teneur en ingrédient (E) est de 0,05-2 % en poids rapportée à la composition de résine époxy globale pour une encapsulation de semi-conducteur.

5. Composition de résine époxy pour une encapsulation de semi-conducteur selon la revendication 1, laquelle comprend de plus un accélérateur de durcissement d'amine.

6. Composition de résine époxy pour une encapsulation de semi-conducteur selon la revendication 1, laquelle est destinée à une utilisation dans l'encapsulation de résine d'un dispositif semi-conducteur comprenant un cadre conducteur présentant une surface plaquée de nickel.

7. Dispositif semi-conducteur qui comprend un élément semi-conducteur et la composition de résine époxy pour une encapsulation de semi-conducteur selon la revendication 1 qui encapsule l'élément semi-conducteur.

8. Dispositif semi-conducteur selon la revendication 7 qui comprend de plus un cadre conducteur présentant une surface plaquée de nickel.
